Europäisches Patentamt

European Patent Office

Office européen des brevets

(19)

(11) EP 0 767 964 B1

(12) EUROPÄISCHE PATENTSCHRIFT

(45) Veröffentlichungstag und Bekanntmachung des Hinweises auf die Patenterteilung:
21.10.1998 Patentblatt 1998/43

(21) Anmeldenummer: 95921687.0

(22) Anmeldetag: 16.06.1995

(51) Int Cl.⁶: $H01B\ 1/22$, $C09J\ 7/02$

(86) Internationale Anmeldenummer:
PCT/DE95/00769

(87) Internationale Veröffentlichungsnummer:
WO 96/00969 (11.01.1996 Gazette 1996/03)

(54) **ANISOTROP LEITENDER KLEBER UND VERFAHREN ZUR HERSTELLUNG EINES ANISOTROP LEITENDEN KLEBERS**

ANISOTROPICALLY CONDUCTING ADHESIVE AND PROCESS FOR ITS PRODUCTION

ADHESIF CONDUCTEUR ANISOTROPE ET PROCEDE DE PRODUCTION D'UN ADHESIF CONDUCTEUR ANISOTROPE

(84) Benannte Vertragsstaaten:
CH DE FR GB IT LI

(30) Priorität: 29.06.1994 DE 4422712
10.05.1995 DE 19517062

(43) Veröffentlichungstag der Anmeldung:
16.04.1997 Patentblatt 1997/16

(73) Patentinhaber: ROBERT BOSCH GMBH
70442 Stuttgart (DE)

(72) Erfinder:
• GRÜNWALD, Werner
 D-70839 Gerlingen (DE)
• HAUG, Ralf
 D-71229 Leonberg (DE)
• BURKHART, Thomas
 D-66994 Dahn (DE)
• MENNING, Martin
 D-66287 Fischbach (DE)
• SCHMIDT, Helmut
 D-66130 Saarbrücken (DE)
• SCHNEIDER, Monika
 D-66538 Neunkirchen (DE)

(56) Entgegenhaltungen:
EP-A- 0 421 709          WO-A-93/01248
US-A- 3 708 387

## Beschreibung

Die Erfindung betrifft einen anisotrop leitenden Kleber nach dem Oberbegriff des Anspruchs 1 und ein Verfahren zur Herstellung eines anisotrop leitenden Klebers.

Stand der Technik

Anisotrop leitende Kleber sind bekannt. Diese weisen in einem Basismaterial, beispielsweise in einem thermoplastischen Basismaterial, feinverteilte leitfähige Teilchen auf. Die leitfähigen Teilchen werden dabei als körnchenförmiges Pulver in dem Basismaterial dispergiert. Die anisotrop leitenden Kleber liegen beispielsweise in Folienform vor und sind geeignet, zwei Kontakte, beispielsweise zwei Leiterbahnen, elektrisch leitend miteinander zu verkleben. Die Leiterbahnen werden unter Druck und Temperatureinwirkung auf die gegenüberliegenden Seiten des Klebers gepreßt, so daß sich das Basismaterial verformt und die in diesem verteilten leitfähigen Teilchen eine elektrisch leitende Verbindung zwischen den aufgebrachten Leiterbahnen herstellen. Das Basismaterial übernimmt dabei eine Haftwirkung zwischen den zu verklebenden, die Leiterbahnen aufweisenden Teilen.

Es wird deutlich, daß eine Auflösung des anisotrop leitenden Klebers, das heißt, der minimal mögliche Abstand zwischen zwei benachbarten elektrisch leitenden Verbindungen, von der Struktur der dispergierten elektrisch leitenden Teilchen abhängt. Damit diese die elektrisch leitende Verbindung in nur einer Richtung ermöglichen, müssen diese einen genügend großen Abstand zueinander aufweisen, damit eine unerwünschte isotrop elektrisch leitende Verbindung vermieden wird. Die kann beispielsweise durch ein zufälliges Koagulieren, das heißt Zusammenballen der elektrisch leitenden Teilchen in dem Basismaterial geschehen. Hierdurch können die bekannten anisotrop leitenden Kleber nur zum Kontaktieren relativ weit auseinander angeordneter Kontakte verwendet werden, da ansonsten eine ausreichend große Kontaktsicherheit nicht gegeben ist.

Vorteile der Erfindung

Der erfindungsgemäße anisotrop leitende Kleber mit den im Anspruch 1 genannten Merkmalen hat demgegenüber den Vorteil, daß durch eine gezielte Koagulation der elektrisch leitfähigen Teilchen die Kontaktsicherheit zwischen zwei benachbarten durch den Kleber führenden elektrisch leitenden Verbindungen verbessert ist. Dadurch, daß die leitfähigen Teilchen von unterhalb einer Perkolationsschwelle feinverteilten Metallteilchen und dispergierten Metallionen gebildet werden, die gezielt zu anisotrop elektrisch leitenden Pfaden koagulierbar sind, wird eine Anisotropie der Kontaktverbindung mit hoher Sicherheit gewährleistet. Als Perkolationsschwelle wird der Zustand verstanden, zu dem die leitfähigen Teilchen jeweils eine zufällige Position in dem Basismatarial einnehmen, und bei dem gerade noch keine metallisch leitfähige Verbindung zwischen zwei benachbarten Teilchen besteht. Durch die Koagulation der leitfähigen Teilchen zu den elektrisch leitenden Pfaden weist der Kleber vorteilhaft zwischen zwei benachbarten leitenden Pfaden Bereiche mit einem verbesserten Isolationsvermögen auf, da hier die Anzahl der leitfähigen Teilchen durch die Koagulation zu den leitenden Pfaden verringert ist.

Durch das erfindungsgemäße Verfahren zur Herstellung des anisotrop leitenden Klebers ist es sehr vorteilhaft möglich, in einfacher Weise an sich aus der Strukturierung von integrierten Schaltungen bekannte Prozeßschritte modifiziert anzuwenden. Dadurch, daß ein mit leitfähigen Teilchen dispergiertes thermoplastisches Basismaterial vorzugsweise über eine Maske belichtet wird, so daß eine lokale Erwärmung in den belichteten Bereichen des Basismatarials erfolgt, und in den belichteten Bereichen anisotrop elektrisch leitende Pfade erzeugt werden, kann über ein großes Prozeßfenster jedes beliebige Layout an anisotrop leitenden Pfaden erzeugt werden, wobei eine sehr hohe Auflösung möglich ist.

In bevorzugter Ausgestaltung der Erfindung ist vorgesehen, daß in das Basismaterial Silberkolloide und Silberionen in ausreichender Menge eingebracht werden, bzw. ausreichend Silber in bestimmter Form eingebracht wird und anschließend Ionen und Kolloide durch geeignete Behandlung erzeugt werden. Durch eine gezielte Reduktion der Silberionen in den Bereichen, in denen die anisotrop leitenden Pfade erzeugt werden sollen, können sehr vorteilhaft elektrisch leitende Bereiche mit dem Silber erzeugt werden, während die die elektrisch leitenden Bereiche umgebenden Bereiche an Silber verarmen, so daß die anisotrop leitenden Pfade mit sehr hoher Auflösung, das heißt mit extrem geringem Abstand zueinander erzielbar sind. Bevorzugt ist vorgesehen, daß das Silber teilweise oder vollständig stabilisiert ist, vorzugsweise durch eine Komplexbildung, so daß bei der Herstellung der anisotrop leitenden Pfade keine spontane Ausfällung des Silbers erfolgt, dieses jedoch gezielt in den Bereichen der gewünschten, elektrisch leitenden Pfade reduziert werden karm.

Weitere vorteilhafte Ausgestaltungen der Erfindung ergeben sich aus den übrigen in den Unteransprüchen genannten Merkmalen.

Die Erfindung wird nachfolgend in Ausführungsbeispielen anhand der zugehörigen Zeichnungen näher erläutert. Es zeigen:

Figur 1    eine Schnittdarstellung durch einen anisotrop leitenden Kleber im Ausgangszustand;

Figur 2    eine Schnittdarstellung durch einen anisotrop leitenden Kleber während einer Formierung und

Figur 3 eine Schnittdarstellung durch einen anisotrop leitenden Kleber im kontaktierten Zustand.

Beschreibung der Ausführungsbeispiele

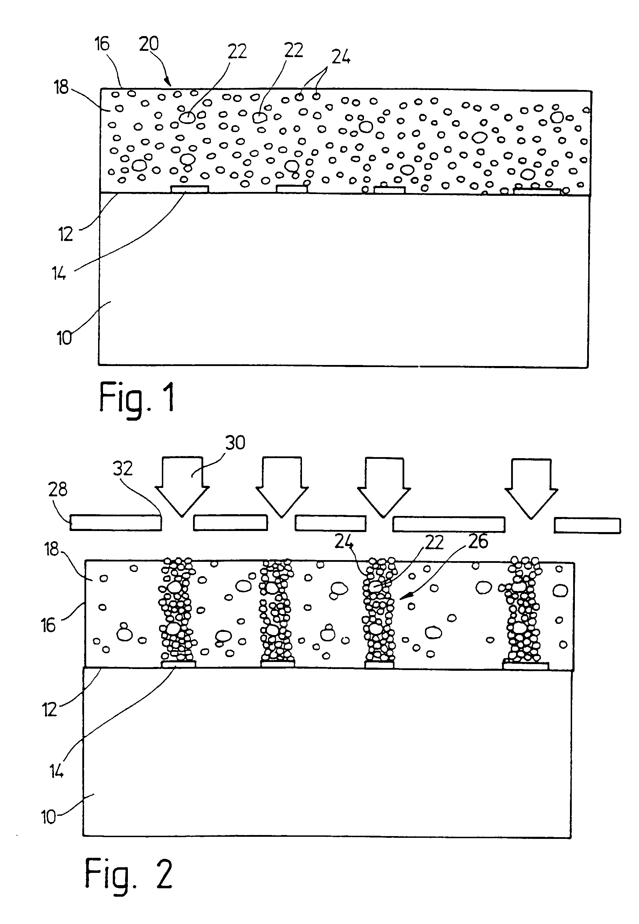

In der Figur 1 ist ein Substrat 10 gezeigt, an dessen Oberfläche 12 Kontaktstellen 14 angeordnet sind. Das Substrat 10 kann beispielsweise jedes beliebige elektronische Bauelement sein. Die Kontaktstellen 14 bilden Außenanschlüsse für auf dem Substrat 10 oder gegebenenfalls in dem Substrat 10 integrierte Bauelemente. Die Kontaktstellen 14 können hierbei beispielsweise durch Leiterbahnen, Kontaktpads oder anderes gebildet sein. Hinsichtlich der Geometrie der Kontaktstellen 14, das heißt deren geometrischen Ausdehnung und geometrischen Form sind keine speziellen Anforderungen gestellt.

Auf der Oberfläche 12 des Substrats 10 ist eine Schicht 16 eines Schmelzklebers aufgebracht. Die Schicht 16 kann hierbei beispielsweise aufgedruckt, aufgewalzt oder andersartig auf das Substrat 10 aufgebracht werden. Die Schicht 16 besitzt ein thermoplastisches Basismaterial 18, in dem elektrisch leitende Teilchen 20 dispergiert, also feinverteilt sind. Die Teilchen 20 bestehen einerseits aus kolloidalen Siberteilchen 22, die unterhalb einer möglichen Perkolationsschwelle in dem Basismaterial 18 verteilt sind. In dem Basismaterial 18 sind weiterhin Silberionen 24 dispergiert. Die Silberteilchen 22 und die Silberionen 24 sind dabei über das gesamte Volumen der Schicht 16 in dem Basismaterial 18 dispergiert. Die Silberteilchen 22 weisen hierbei einen Durchmesser in einem nm-Bereich auf. Während des Aufbringens der Schicht 16 werden die Kontaktstellen 14 an beziehungsweise auf dem Substrat 10 von dem Basismaterial 18 umschlossen.

In der Figur 2 ist die Strukturierung von anisotrop leitenden Pfaden 26 durch die Schicht 16 verdeutlicht. Hierzu wird die Schicht 16 über eine Maske 28 mit UV-Licht 30 belichtet. Die Maske 28 besitzt hierzu Öffnungen 32, deren Layout vorzugsweise den zu kontaktierenden Kontaktstellen 14 des Substrats 10 entsprechen. Das UV-Licht 30 fällt somit durch die Öffnungen 32 der Maske 28 auf die die Kontaktstellen 14 überdeckenden Bereiche der Schicht 16. Innerhalb der belichteten Bereiche wird das UV-Licht 30 von den Silberteilchen 22 absorbiert, die sich somit erwärmen. Durch die Erwärmung der Silberteilchen 22 kommt es in dem Basismaterial 18 zu einer lokalen Erwärmung, so daß das Basismaterial 18 in diesen Bereichen dünnflüssig wird. Innerhalb der so entstandenen dünnflüssigen Bereiche werden die Silberionen 24 beweglich. Die Silberteilchen 22 bilden für die Silberionen 24 Kondensationskeime, so daß die Silberionen 24 von den Silberteilchen 22 angezogen werden und sich an diesen ablagern. Durch die andauernde Ablagerung der Silberionen 24 wachsen die Kondensationskeime zu den anisotrop leitenden Pfaden 26 auf. Infolge des sich hierbei bildenden Konzentrationsgradienten der Silberionen 24 werden auch weiter entfernt angeordnete Silberionen 24 an die entstehenden Zentren der Silberteilchen 22 mit den darum anwachsenden Silberionen 24 herangezogen, so daß sich schließlich die elektrisch leitenden Pfade 26 ergeben. Über die Dauer beziehungsweise die Intensität des UV-Lichtes 30 kann hierbei der Konzentrationsgrad von Silberteilchen 22 beziehungsweise Silberionen 24 zu den elektrisch leitenden Pfaden 26 eingestellt werden. Durch das Anwachsen der Silberionen 24 an den elektrisch leitenden Pfaden 26 werden diese gleichzeitig in den zwischen zwei benachbarten elektrisch leitenden Pfaden liegenden Bereichen des Basismaterials 18 ausgedünnt, so daß zwischen den benachbarten Pfaden 26 ein gutes Isolationsverhältnis besteht. Nach Abschalten des UV-Lichts 30 und Entfernen der Maske 28 kühlt das Basismaterial 18 aus, so daß die verflüssigten Bereiche erhärten und damit die gebildeten leitfähigen Pfade 26 in ihrer Position verbleiben.

Nachfolgend wird ein weiteres vorteilhaftes Beispiel zur Erzielung von anisotrop leitenden Pfaden in einem Kleber erläutert. Soweit es für das Verständnis sinnvoll erschien, wurde auf Bezugszeichen der Figuren 1 bis 2 zurückgegriffen, obwohl das Herstellungsverfahren anders abläuft.

Zunächst wird das Basismaterial 18 synthetisiert. Hierzu wird 200 ml absolutiertes Ethanol unter Rühren zum Sieden erhitzt. Dann wird langsam eine Mischung aus 69,63 g (=27.5 mol%) Dichlordiphenylsilan, 98,75 g (=70 mol%) Dichlormethylvinylsilan und 5,20 g (=2.5 mol%) Tetraethoxysilan zugetropft. Nach Beendigung der Zugabe wird das Gemisch für 2 h unter Rückfluß gekocht, wobei das bei der Reaktion freiwerdende HCl-Gas über den Rückflußkühler entweicht und mit Hilfe eines Schlauches in einen Behälter mit Wasser geleitet wird. Das Reaktionsgemisch färbt sich während der Reaktion leicht gelblich. Durch Abdestillieren des Lösungsmittels im Wasserstrahlvakuum (30 mbar) bei 70 °C erhält man eine leicht viskose Flüssigkeit. Dieses Vorkondensat wird nun so oft in 200 ml Ethanol aufgenommen und bei 70 °C und 30 mbar wieder eingeengt, bis es Neutralreaktion bezüglich des pH-Wertes zeigt. Zu der zurückbleibenden, klaren gelblichen Lösung wird die gleiche Volumenmenge Aceton zugegeben und die Lösung zum Sieden erhitzt und diese dann rasch mit 73,8 ml 0.1 normaler wäßriger Salzsäure (=4.0 mol Wasser) versetzt. Die Lösung wird dann 3 h unter Rückfluß gekocht, wobei eine weiße Trübung, die das ausfallende Kondensat hervorruft, auftritt. Nach Abziehen des Lösungsmittels im Wasserstrahlvakuum bei 70 °C erhält man ein Hydrolysat, welches dann zweimal in der gleichen Menge Aceton gelöst und jeweils wieder bei 30 mbar und 70 °C eingedampft wird. Der zurückbleibende, viskose, weißtrübe Rückstand wird anschließend im Wasserstrahlvakuum bei 180 °C so lange erhitzt, bis sich im IR-Spektrum der Probe folgende Extinktionsverhältnisse zwischen den OH-Banden bei 3620 cm$^{-1}$ und 3400 cm$^{-1}$ und der Phenyl-CH-Bande bei 3070 cm$^{-1}$ er-

geben:

$$E_{3620}/E_{3070} = 0.358 \pm 0.03$$

und

$$E_{3400}/E_{3070} = 0.624 \pm 0.06$$

Man erhält ein Ormocer-Harz auf der Basis von Diphenyldichlorsilan, Methylvinyldichlorsilan und Tetraethoxysilan.

Die so erhaltene Matrix des Basismaterials 18 wird anschließend zu dem vollständigen Klebstoffsystem mit den leitfähigen Teilchen 20 synthetisiert. Hierzu werden 2,3633 g des zuvor synthetisierten Ormocer-Harzes mit 1.0128 g (0,00529 mol) AMDES (Aminopropylmethyldiethoxysilan) 30 Minuten bei 140 °C aminofunktionalisiert und dann auf 100 °C abgekühlt. Dann werden 2,9107 g (0,0174 mol) Silberacetat in 5 ml Aceton gelöst und versetzt mit 2,8958 g (0,0173 mol) DIAMO. Diese Silbersalz-Lösung wird zu dem aminofunktionalisierten Ormocer-Harz gegeben und das Gemisch 5-10 Minuten bei 100 °C gerührt, bis die Viskosität stark zunimmt. Dann wird 2,0257 g (0,0105 Epoxidäquivalent) Gy266 (Fa. Araldit) zugetropft, welches vorher in 1,5195 g Aceton gelöst wurde. Nun wird bei 100 °C unter Rühren die Reaktion aufrechterhalten, bis die gewünschte Viskosität, die durch den "B-stage"-Test bestimmt wird, erreicht ist.

Nach Abschluß der Reaktion erhält man ein Basismaterial 18, das mit einem Masseanteil von ca. 30 % Silber gefüllt ist. Das mit dem Silber als leitfähige Teilchen 20 versehene Basismaterial 18 kann nunmehr in der Schicht 16 auf ein Substrat 10 aufgebracht werden. Die Schichtdicke beträgt beispielsweise 10 μm. Das Aufbringen der Schicht 16 kann mittels üblicher, allgemein bekannter Verfahren, beispielsweise Aufrakeln, erfolgen.

Anschließend wird die Schicht 16 einer Laserbehandlung unterzogen. Hierzu wird beispielsweise ein im VIS-Bereich und Multiline-Modus betriebener Argon-Ionen-Laser mit einem Laserspotdurchmesser von 60 μm verwendet. Je nach Art der zu erzielenden, anisotrop elektrisch leitenden Pfade 26 kann die Leistung des Lasers variiert werden. Sollen beispielsweise Leiterbahnen erzeugt werden, kann die Leistung 1,3 W betragen. Der Laser wird in dem sogenannten "Direkt-Laser-Writing"-Verfahren über die Schicht 16 geführt. Hierbei kann das Substrat 10 mit der Schicht 16 an dem Laserspot vorbeigeführt werden. Das Substrat 10 ist hierzu beispielsweise auf einem entsprechenden X-Tisch angeordnet. Die Vorschubgeschwindigkeit beträgt beispielsweise 0,5 mm/sec. Entsprechend der vorgegebenen Bewegung des Substrats 10 wird in der Schicht 16 eine Leiterbahn gezielt in den Bereichen strukturiert, in denen die Laserbehandlung erfolgt. Während der Laserbehandlung erfolgt eine gezielte, das heißt lokale Erwärmung der Schicht 16, in der die Stabilisierung des Silbers aufgelöst wird. Hierbei findet beispielsweise eine thermische Zerstörung von Silberkomplexen statt. Dies hat eine erhöhte Beweglichkeit der Silberionen in bestimmten Bereichen zur Folge. Im Zentrum der Wechselwirkung reichert sich Silber an und wird gezielt reduziert. Hierdurch entsteht eine Diffusionssenke für die Silberionen. Die Bereiche mit Silber im Zentrum wachsen zu den elektrisch leitenden Pfaden 26 an, während um diese Bereiche herum eine Verarmung mit Silberionen stattfindet. Die gezielte Reduktion des Silbers wird durch während der lokalen Erwärmung des Basismaterials 16 entstehende Zersetzungsprodukte des Basismaterials 16 oder von Komplexierungsmitteln des stabilisierten Silbers unterstützt. Diese wirken als Reduktionsmittel für die Reduktion des Silbers.

Nach einem weiteren Beispiel kann der Laserspot des Lasers auf eine bestimmte Stelle der Schicht 16 fokussiert werden. Diese gewählte Stelle wird für eine bestimmte Zeitdauer, beispielsweise von 10 sec., bestrahlt, wobei die Laserleistung beispielsweise 1 W beträgt. Infolge der Bestrahlung über der gewählten Zeitdauer entsteht an dieser Stelle ein Silber-Pitsch, also ein einzelner, definierter, elektrisch leitender Pfad 26. Hierbei laufen die gleichen chemischen Vorgänge innerhalb der Schicht 16 ab, die zu der gezielten Reduktion des Silbers in dem bestrahlten Bereich führen, so daß Silber-Kolloide entstehen, die die elektrisch leitende Verbindung herstellen. In den nicht bestrahlten Bereichen bleibt das Silber stabil, so daß durch die Verteilung des Silbers in dem Basismaterial 16 unterhalb der Perkolationsschwelle eine isotrope Leitfähigkeit ausgeschlossen ist. Darüber hinaus verarmen die Silberionen im unmittelbaren Nachbarbereich des erzeugten Silber-Pitsches, so daß hiermit die Anisotropie der Leitfähigkeit verbessert ist.

Insgesamt wird deutlich, daß durch eine geeignete Komplexierung des Basismaterials 18 ein sehr hoher Füllgrad an Silber erreicht werden kann. In dem gezeigten Beispiel ist ein Massenanteil von 30 % erwähnt, der aber auch wesentlich höher, beispielsweise bei 70 % liegen kann. Mittels der Synthese des Basismaterials 18 wird ein Ausfällen des Silbers verhindert. Gleichzeitig können während der Komplexierung Stoffe eingebaut werden, die die nachfolgende Reduktion des Silbers unter Einfluß einer Belichtung und/oder einer Laserbehandlung ermöglichen beziehungsweise unterstützen.

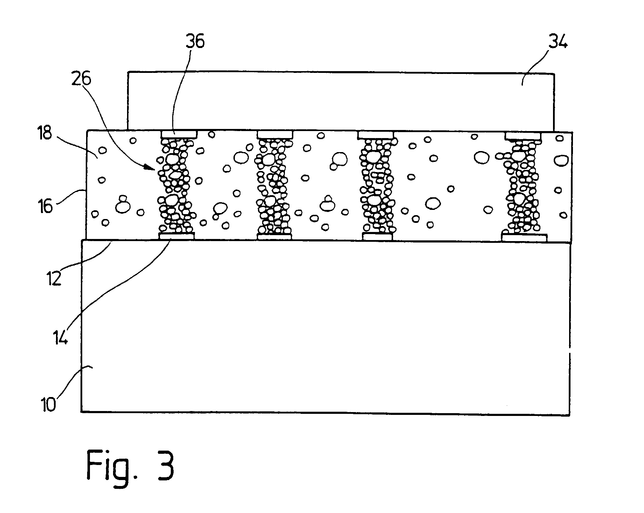

Anhand der Figur 3 wird eine Verbindung mittels der Schmelzkleber-Schicht 16 verdeutlicht, wobei diese aufgrund der UV-Belichtung und/oder der Laserbehandlung hergestellt sein kann. Gleiche Teile wie in den Figuren 1 und 2 sind mit gleichen Bezugszeichen versehen und nicht nochmals erläutert.

Im gezeigten Beispiel ist das Substrat 10 mit einem weiteren Substrat 34 über die Schmelzkleber-Schicht 16 verklebt. Das Substrat 34 ist ebenfalls nur beispielhaft gewählt und kann beispielsweise ein integrierte elektronische Bauelemente aufweisender Chip sein. Das Substrat 34 besitzt Kontaktstellen 36, die mit den Kontaktstellen 14 des Substrats 10 elektrisch leitend verbunden werden sollen. Das Substrat 34 wird dabei mit seinen in Richtung der Schmelzkleberschicht 16 gerichteten Kontaktstellen 36 über dem Substrat 10 positioniert. Die Positionierung erfolgt dabei so, daß die zu kontaktierenden Kontaktstellen 14 beziehungsweise 36 gegenüberliegen. Da das Anschlußraster von zu verbindenden Substraten 10 und 34 an sich bekannt ist, wird über das Layout der Maske 28 gewährleistet, daß zwischen jedem der zu kontaktierenden Kontaktstellen 14 beziehungsweise 36 ein elektrisch leitender Pfad 26 vorhanden ist. Die Substrate 10 und 34 werden nunmehr unter Erwärmung der Schmelzkleber-schicht 16 zusammengefügt. Durch diese Erwärmung wird das Basismaterial 18 erweicht, wobei die Erwärmungstemperatur je nach Material des Basismaterials 18 einstellbar ist. Besteht das Basismaterial 18 beispielsweise auf Siloxanbasis, können die Substrate 10 und 34 beispielsweise bei einer Temperatur von ca. 120 °C miteinander verklebt werden. Das erweichte Basismaterial 18 übernimmt hierbei eine flächige Haftvermittlung zwischen den Substraten 10 und 34, während die elektrisch leitende Verbindung über die Kontaktstellen 14, die Pfade 26 und die Kontaktstellen 36 erfolgt. Das entstandene Verbundsystem wird anschließend wärmebehandelt, so daß die Schmelzkleber-Schicht 16 aushärtet. Dies kann beispielsweise bei einer Temperatur von 120 °C über einen längeren Zeitraum oder bei einer höheren Temperatur in einem kürzeren Zeitraum geschehen. Die Aushärtetemperatur kann in Abhängigkeit der Temperaturbelastbarkeit der Substrate 10 beziehungsweise 34 gewählt sein.

Mit dem erfindungsgemäßen anisotrop leitenden Kleber ist ein System geschaffen, das sich einfach verarbeiten und handhaben läßt. Insbesondere durch das Herausführen von leitfähigen Teilchen aus den Bereichen zwischen zwei leitenden Pfaden 26 wird die Anisotropie der Schmelzkleberschicht 16 wesentlich verbessert. Die entstandenen leitfähigen Pfade 26 zeichnen sich durch eine verbesserte elektrische Leitfähigkeit und Strombelastbarkeit gegenüber bekannten anisotropen Klebern aus. Die leitfähigen Pfade 26 können an beliebigen Stellen einer großflächig vorhandenen Schmelzkleberschicht 18 strukturiert werden, so daß in einem einfachen verfahrenstechnischen Prozeß jede beliebige Konfiguration einer elektrisch leitenden Verbindung zwischen zwei Substraten realisierbar ist. Darüber hinaus können mit dem erfindungsgemäßen anisotrop leitenden Kleber hochbelastbare Verbindungen zwischen den zu verklebenden Substraten 10 und 34 hergestellt werden. Durch die ganzflächige mechanische Fixierung der Substrate 10 beziehungsweise 34 über das Basismaterial 18 unterliegen die elektrisch leitenden Verbindungen einer geringen mechanischen Belastung, so daß die Kontaktsicherheit der gesamten Anordnung verbessert ist. Eventuell auftretende Spannungen können durch die Elastizität des Basismaterials 18 abgefangen werden, so daß beispielsweise unterschiedliche thermische Ausdehnungen auf seiten des Substrats 10 oder des Substrats 34 ohne Verschlechterung der Kontaktsicherheit ausgeglichen werden können.

**Patentansprüche**

1. Anisotrop leitender Kleber mit in einem thermoplastischen Basismaterial leitfähigen, unterhalb einer Perkolationsschwelle feinverteilten Teilchen, **dadurch gekennzeichnet,** daß die Teilchen (20) Metallteilchen und Metallionen sind.

2. Kleber nach Anspruch 1, **dadurch gekennzeichnet**, daß die Teilchen (20) unter Einfluß einer Belichtung und/oder Erwärmung sich in bestimmten Bereichen anreichern.

3. Kleber nach einem der vorhergehenden Ansprüche, **dadurch gekennzeichnet,** daß die Teilchen (20) von kolloidalen Silberteilchen (22) und Silberionen (24) gebildet werden.

4. Kleber nach einem der vorhergehenden Ansprüche, **dadurch gekennzeichnet,** daß die Silberteilchen (22) eine Korngröße in nm-Bereich aufweisen.

5. Kleber nach einem der vorhergehenden Ansprüche, **dadurch gekennzeichnet,** daß die Silberteilchen (22) agglomeriert sind und eine Korngröße von 5 bis 50 µm aufweisen.

6. Verfahren zur Herstellung eines anisotrop leitenden Klebers, insbesondere eines Klebers nach einem der Ansprüche 1 bis 5, **dadurch gekennzeichnet,** daß in einem thermoplastischen Basismaterial (18) vorhandene Metallionen durch gezielte Erwärmung und/oder Belichtung in bestimmten Bereichen angereichert und reduziert werden, so daß in diesen bestimmten Bereichen elektrisch leitende Pfade (26) entstehen.

7. Verfahren nach Anspruch 6, **dadurch gekennzeichnet,** daß in das Basismaterial (18) Metallkolloide, insbesondere Silberkolloide (22) und Metallionen, insbesondere Silberionen (24) eingebracht werden.

8. Verfahren nach Anspruch 6, **dadurch gekennzeichnet,** daß in das Basismaterial (18) Metall, insbesondere Silber in geeigneter Form eingebracht wird und dieses anschließend zu Metallkolloiden, insbesondere Silberkolloiden (22) und Metallionen, insbesondere Silberionen (24) umgewandelt wird.

9. Verfahren nach einem der vorhergehenden Ansprüche, **dadurch gekennzeichnet,** daß eine Reduktion der Metallionen, insbesondere Silberionen gezielt in dem Bereich durchgeführt wird, in dem die elektrisch leitenden Pfade (26) erzeugt werden.

10. Verfahren nach einem der vorhergehenden Ansprüche, **dadurch gekennzeichnet,** daß ein geeignetes Reduktionsmittel für die gezielte Reduktion der Metallionen, insbesondere Silberionen in die Matrix eingebracht wird oder als Zersetzungsprodukt der Matrix oder eines Komplexierungsmittels entsteht.

11. Verfahren nach einem der vorhergehenden Ansprüche, **dadurch gekennzeichnet,** daß die Reduktion mittels einer lokalen Laserbehandlung durchgeführt wird.

12. Verfahren nach einem der vorhergehenden Ansprüche, **dadurch gekennzeichnet,** daß das Metall, insbesondere Silber teilweise oder vollständig stabilisiert ist.

13. Verfahren nach einem der vorhergehenden Ansprüche, **dadurch gekennzeichnet,** daß die Belichtung über eine Maske (28) erfolgt, die entsprechend eines wählbaren Layouts Öffnungen (32) aufweist.

14. Verfahren nach einem der vorhergehenden Ansprüche, **dadurch gekennzeichnet,** daß die Belichtung mittels eines Lichts erfolgt, welches von den kolloiden Ionen oder leitfähigen Teilchen absorbiert wird.

15. Verfahren nach Anspruch 14, **dadurch gekennzeichnet,** daß die Belichtung mit UV-Licht erfolgt.

16. Verfahren nach einem der vorhergehenden Ansprüche, **dadurch gekennzeichnet,** daß ein Anreicherungsgrad der Teilchen in den anisotrop leitenden Pfaden über eine Dauer und/oder eine Intensität der Belichtung und/oder der Laserbehandlung einstellbar ist.

**Claims**

1. Anisotropically conducting adhesive comprising, in a thermoplastic base material, conductive particles which below a percolation threshold are finely divided, characterized in that the particles (20) are metal particles and metal ions.

2. Adhesive according to Claim 1, characterized in that the particles (20) accumulate in certain regions under the influence of heating and/or exposure to light.

3. Adhesive according to one of the preceding claims, characterized in that the particles (20) are formed by colloidal silver particles (22) and silver ions (24).

4. Adhesive according to one of the preceding claims, characterized in that the silver particles (22) have a size in the nm range.

5. Adhesive according to one of the preceding claims, characterized in that the silver particles (22) are agglomerated and have a size of from 5 to 50 $\mu$m.

6. Process for preparing an anisotropically conducting adhesive, especially an adhesive according to one of Claims 1 to 5, characterized in that metal ions in a thermoplastic base material (18) are accumulated in defined regions by means of targeted heating and/or exposure to light and are reduced, so that electrically conducting paths (26) are formed in these defined regions.

7. Process according to Claim 6, characterized in that metal colloids, especially silver colloids (22), and metal ions, especially silver ions (24), are introduced into the base material (18).

8. Process according to Claim 6, characterized in that metal, especially silver, in appropriate form is introduced into the base material (18) and this metal is subsequently converted into metal colloids, especially silver colloids (22), and metal ions, especially silver ions (24).

9. Process according to one of the preceding claims, characterized in that reduction of the metal ions, especially silver ions, is carried out in a targeted manner in the region in which the electrically conducting paths (26) are produced.

10. Process according to one of the preceding claims, characterized in that a suitable reducing agent for the targeted reduction of the metal ions, especially silver ions, is introduced into the matrix or forms as a decomposition product of the matrix or of a complexing agent.

11. Process according to one of the preceding claims, characterized in that reduction is carried out by means of local laser treatment.

12. Process according to one of the preceding claims, characterized in that the metal, especially silver, is partly or completely stabilized in a form.

13. Process according to one of the preceding claims, characterized in that exposure takes place through a mask (28) which has openings (32) corresponding to a selectable layout.

**14.** Process according to one of the preceding claims, characterized in that exposure takes place by means of a light which is absorbed by the colloidal ions or conductive particles.

**15.** Process according to Claim 14, characterized in that exposure takes place with UV light.

**16.** Process according to one of the preceding claims, characterized in that a degree of accumulation of the particles in the anisotropically conducting paths can be established via a duration and/or an intensity of exposure and/or of laser treatment.

## Revendications

**1.** Adhésif conducteur anisotrope avec des particules finement divisées, conductrices, dans un matériau de base thermoplastique, en dessous d'un seuil de percolation,
caractérisé en ce que
les particules (20) sont des particules métalliques et des ions métalliques.

**2.** Adhésif selon la revendication 1,
caractérisé en ce que
les particules (20) s'enrichissent dans des zones déterminées sous l'influence d'une exposition et/ou d'un chauffage.

**3.** Adhésif selon l'une des revendications précédentes,
caractérisé en ce que
les particules (20) sont formées de particules d'argent colloïdales (22) et d'ions argent (24).

**4.** Adhésif selon l'une des revendications précédentes,
caractérisé en ce que
les particules d'argent (22) présentent une granulométrie de l'ordre du nanomètre.

**5.** Adhésif selon l'une des revendications précédentes,
caractérisé en ce que
les particules d'argent sont agglomérées et présentent une granulométrie de 5 à 50 μm.

**6.** Procédé de fabrication d'un adhésif conducteur anisotrope, en particulier d'un adhésif selon l'une des revendications 1 à 5,
caractérisé en ce que
les ions métalliques présents dans un matériau de base thermoplastique (18) sont enrichis et réduits par un chauffage et/ou une exposition ciblée dans des zones déterminées, si bien que dans ces zones déterminées il apparaît des voies conductrices de l'électricité (26).

**7.** Procédé selon la revendication 6,
caractérisé en ce que
l'on introduit dans le matériau de base (18) des colloïdes métalliques, en particulier des colloïdes d'argent (22) et des ions métalliques, en particulier des ions argent (24).

**8.** Procédé selon la revendication 6,
caractérisé en ce que
l'on introduit dans le matériau de base (18) un métal, en particulier de l'argent sous une forme appropriée, puis en ce qu'on transforme celui-ci en colloïdes métalliques, en particulier en colloïdes d'argent (22) et en ions métalliques, en particulier en ions d'argent (24).

**9.** Procédé selon l'une des revendications précédentes,
caractérisé en ce qu'on produit une réduction des ions métalliques, en particulier des ions argent de façon ciblée dans la zone dans laquelle la voie conductrice de l'électricité (26) est produite.

**10.** Procédé selon l'une des revendications précédentes,
caractérisé en ce qu'
on introduit un réducteur approprié pour la réduction ciblée des ions métalliques, en particulier des ions argent dans la matrice, ou en ce qu'il apparaît comme produit de décomposition de la matrice ou d'un agent de complexation.

**11.** Procédé selon l'une des revendications précédentes,
caractérisé en ce qu'
on procède à la réduction au moyen d'un traitement local au laser.

**12.** Procédé selon l'une des revendications précédentes,
caractérisé en ce que
le métal, en particulier l'argent, est partiellement ou entièrement stabilisé.

**13.** Procédé selon l'une des revendications précédentes,
caractérisé en ce qu'
on procède à l'exposition par l'intermédiaire d'un masque (28) qui présente de façon correspondante un dessin d'ouvertures (32) que l'on peut choisir.

**14.** Procédé selon l'une des revendications précédentes,
caractérisé en ce qu'
on procède à l'exposition au moyen d'une lumière qui est absorbée par les ions colloïdes ou les particules conductrices.

15. Procédé selon l'une des revendications précédentes,
caractérisé en ce que
l'exposition est faite avec une lumière U.V.

16. Procédé selon l'une des revendications précédentes,
caractérisé en ce qu'
on peut régler le degré d'enrichissement des particules dans les voies conductrices anisotropes par
l'intermédiaire de la durée et/ou de l'intensité de
l'exposition et/ou du traitement au laser.

Fig. 1

Fig. 2

Fig. 3